# EUROPÄISCHE PATENTSCHRIFT

(11) **EP 3 591 986 B1**
(45) Veröffentlichungstag und Bekanntmachung des Hinweises auf die Patenterteilung: **31.03.2021**
(21) Anmeldenummer: 19174693.2
(22) Anmeldetag: 15.05.2019
(51) Int. Cl.: H04Q 9/00, G01R 31/396

(54) **SCHALTUNGSANORDNUNG**
SWITCHING ASSEMBLY
ASSEMBLAGE DE CIRCUIT

(30) Priorität: 04.07.2018 DE 102018210966
(43) Veröffentlichungstag der Anmeldung: 08.01.2020
(73) Patentinhaber: Volkswagen AG, 38440 Wolfsburg (DE)
(72) Erfinder: JUHL, Jochen, 31702 Lüdersfeld (DE)

(56) Entgegenhaltungen:
- US-A1- 2013 346 783
- US-A1- 2016 193 973
- US-A1- 2019 120 907

## Beschreibung

Die vorliegende Erfindung betrifft eine Schaltungsanordnung für ein Batteriemanagementsystem, insbesondere eines Fahrzeuges. Ferner bezieht sich die Erfindung auf ein Verfahren zur Anpassung wenigstens einer Zellinformation.

Aus dem Stand der Technik ist es bekannt, dass bei Batteriesystemen eine Überwachung von Zellen durchgeführt wird. Diese Überwachung dient zum Beispiel dazu, Temperaturwerte und/oder Spannungswerte jeweils als Zellinformation bei einzelnen Zellen zu erfassen und mit vorgegebenen Grenzwerten zu vergleichen. Auf diese Weise kann ein sicherer Betrieb des Batteriesystems sichergestellt werden.

Oft ist es dabei notwendig, zur Übertragung dieser Zellinformation zum Beispiel zu einem Batteriemanagementsystem und/oder zu einem Battery Management Controller (BMC) und/oder zu einem Steuergerät eines Fahrzeuges eine Anpassung der Zellinformation vorzunehmen. Beispielsweise wird die Zellinformation über ein Bussystem des Fahrzeuges übertragen, sodass die Zellinformation in ein für dieses Bussystem passendes Datenpaket integriert werden muss.

Um bei der Übertragung eine zuverlässige Fehlererkennung durchzuführen, sind diverse Kontrollverfahren bekannt. Insbesondere ist es hierbei erforderlich, Sicherheitsstandards, wie einen ASIL-Standard (Automotive Safety Integrity Level), einzuhalten.

Aus den Schriften US 2013 / 346783 A1, US 2016 / 193973 A1, US 2019 / 120907 A1, WO 2012/048929 A1, DE 10 2011 082937 A1 sowie DE 10 2009 046564 A1 sind entsprechend gattungsgemäße Schaltungsanordnungen und/oder -verfahren bekannt.

Nachteilhaft bei bekannten Lösungen ist allerdings, dass eine ausreichende und zuverlässige Kontrolle mit einem hohen technischen Aufwand und/oder Kostenaufwand verbunden ist.

Es ist daher eine Aufgabe der vorliegenden Erfindung, die voranstehend beschriebenen Nachteile bei der Überwachung von Zellen von Batteriesystemen zumindest teilweise zu beheben. Insbesondere ist es eine Aufgabe der vorliegenden Erfindung, eine verbesserte und/oder kostengünstigere Lösung zur Anpassung und/oder Kontrolle einer Zellinformation bei einem Batteriemanagementsystem und/oder BMC eines Fahrzeuges vorzuschlagen.

Die voranstehende Aufgabe wird gelöst durch eine Schaltungsanordnung, vorzugsweise durch eine elektronische Vorrichtung, mit den Merkmalen des Anspruchs 1 und durch ein Verfahren mit den Merkmalen des Anspruchs 9. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Schaltungsanordnung beschrieben sind, selbstverständlich auch im Zusammenhang mit dem erfindungsgemäßen Verfahren, und jeweils umgekehrt, sodass bezüglich der Offenbarung zu den einzelnen Erfindungsaspekten stets wechselseitig Bezug genommen wird beziehungsweise werden kann.

Die Aufgabe wird insbesondere gelöst durch eine Schaltungsanordnung, vorzugsweise eine elektronische Vorrichtung. Die Schaltungsanordnung kann dabei Teil eines Systems, wie eines Batteriemanagementsystems, insbesondere eines Fahrzeuges, sein. Hierbei weist die Schaltungsanordnung zum Beispiel Elektronikkomponenten auf, welche vorteilhafterweise auf einer Leiterplatte im Fahrzeug angeordnet sind.

Vorteilhaft ist es zudem, wenn das Fahrzeug als ein Kraftfahrzeug, insbesondere gleisloses Landkraftfahrzeug, ausgebildet ist, zum Beispiel als ein Hybridfahrzeug, das eine Brennkraftmaschine und eine Elektromaschine zur Traktion umfasst. Auch kann das Fahrzeug als ein Elektrofahrzeug ausgebildet sein, vorzugsweise mit einem Hochvolt-Bordnetz und/oder einem Elektromotor. Insbesondere kann das Fahrzeug als ein Brennstoffzellenfahrzeug und/oder Personenkraftfahrzeug ausgebildet sein. Bevorzugt ist bei Ausführungsformen von Elektrofahrzeugen kein Verbrennungsmotor beim Fahrzeug vorgesehen, es wird dann ausschließlich durch elektrische Energie angetrieben.

Das Fahrzeug weist besonders bevorzugt ein (wiederaufladbares) Batteriesystem mit dem Batteriemanagementsystem und/oder dem BMC auf. Das Batteriesystem kann zum Beispiel ein oder mehrere (Batterie-) Zellen aufweisen, welche wiederaufladbar ausgestaltet sind. Zur Zellüberwachung kann vorzugsweise wenigstens ein Überwachungsmittel, wie ein Zellcontroller und/oder ein ASIC (anwendungsspezifische integrierte Schaltung), bei den (und/oder für die) einzelnen Zellen des Batteriesystems angeordnet sein. Das Überwachungsmittel kann zum Beispiel eine Zellspannung und/oder eine Zelltemperatur der jeweiligen Zelle als Zellinformation erfassen. Es kann zum Beispiel ein einziges Überwachungsmittel für mehrere Zellen oder ein Überwachungsmittel pro Zelle genutzt werden. Eine Übertragung der Zellinformation von dem jeweiligen Überwachungsmittel an zum Beispiel ein Batteriemanagementsystem (BMS) erfolgt beispielsweise über ein Übertragungssystem und/oder Übertragungsmittel, wie einer Serial Peripheral Interface (SPI) Schnittstelle oder einer Local Interconnect Network (LIN) Schnittstelle oder gemäß einem Transceiver Physical Layer (TPL) Protokoll. Außerdem kann es möglich sein, dass die Zellinformation durch ein weiteres Gerät, wie ein Steuergerät des Fahrzeuges und/oder ein BMC, ausgewertet wird. Damit kann ein sicherer Betrieb des Batteriesystems gewährleistet werden. Es kann möglich sein, dass das wenigstens eine Überwachungsmittel (jeweils) als ein Zellcontroller ausgebildet ist, welcher mit dem BMC und/oder direkt mit dem übrigen Fahrzeug über das Kommunikationssystem kommuniziert. Somit kann das Kommunikationssystem gegebenenfalls als ein Battery-CAN-Bus ausgebildet sein, und als ein Kommunikationspfad zwischen dem (jeweiligen) Zellcontroller und dem BMC dienen. Durch das BMC kann z. B. auch eine Schützsteuerung und/oder das Aussenden von Balancing-Anforderungen an den (jeweiligen) Zellcontroller durchgeführt werden.

Allerdings ist es möglich, dass das weitere Gerät einen Empfang der Zellinformation über ein Kommunikationssystem, wie ein Bussystem des Fahrzeuges, erwartet. Daher kann eine Übersetzung (das heißt Anpassung) der über das Übertragungsmittel beziehungsweise Übertragungssystem übertragenen Zellinformation an das Kommunikationssystem (des Fahrzeuges) notwendig sein.

Erfindungsgemäß kann zur Anpassung wenigstens einer Zellinformation (das heißt eine Information über wenigstens eine Batteriezelle) an ein Kommunikationssystem, insbesondere des Fahrzeuges, wenigstens eine der nachfolgenden (Elektronik-) Komponenten vorgesehen sein:
- ein erstes Verarbeitungselement, wie ein erster integrierter Schaltkreis und/oder Mikrocontroller, zur Generierung einer Nachricht (insbesondere als erste Daten) sowie einer Prüfinformation gemäß einer ersten Verarbeitung, wobei die Nachricht für die Zellinformation spezifisch ist, vorzugsweise die Zellinformation umfasst,
- wenigstens (oder genau oder maximal) ein zweites Verarbeitungselement, wie ein zweiter integrierter Schaltkreis und/oder Mikrocontroller, zur Generierung der gleichen Nachricht (insbesondere als zweite Daten) gemäß wenigstens (oder genau) einer zweiten Verarbeitung, sodass vorzugsweise diese Nachricht ebenfalls die Zellinformation umfasst,
- eine Kommunikationssystemschnittstelle, wie ein elektrischer Anschluss oder ein weiterer integrierter Schaltkreis und/oder Mikrocontroller und/oder ein Transceiver, zur Ausgabe einer Ausgabebotschaft an das Kommunikationssystem.

Hierbei kann vorgesehen sein, dass die Ausgabebotschaft sich zumindest teilweise aus der (durch das zweite Verarbeitungselement generierten) Nachricht gemäß der zweiten Verarbeitung sowie der Prüfinformation (gemäß der ersten Verarbeitung) zusammensetzt, sodass die Ausgabebotschaft für die erste und zweite Verarbeitung spezifisch ist. In anderen Worten weist die Ausgabebotschaft sowohl Daten auf, welche bei der ersten Verarbeitung zur Generierung der Nachricht hervorgingen, als auch Daten auf, welche bei der zweiten Verarbeitung zur Generierung der damit gleichen Nachricht hervorgingen. Diese beiden Nachrichten sind im Normalfall gleich und lediglich im Fehlerfall unterschiedlich. Die Prüfinformation korreliert jedoch mit der ersten Verarbeitung, ist zum Beispiel abhängig von der gemäß der ersten Verarbeitung generierten Nachricht. Ein Fehler bei der ersten oder zweiten Verarbeitung kann daher durch einen Vergleich der Prüfinformationen mit der Nachricht gemäß der zweiten Verarbeitung erkannt werden. Es wird daher der Vorteil erzielt, dass nur bei einer fehlerfreien ersten und zweiten Verarbeitung die Ausgabebotschaft ebenfalls als fehlerfrei erkannt wird. Somit ist eine gegenseitige Überwachung durch die Verarbeitungselemente möglich.

Des Weiteren kann es möglich sein, dass die Zellinformation eine Information über eine Spannung und/oder Temperatur einer Zelle eines Batteriesystems, insbesondere des Fahrzeuges, aufweist. Zum Beispiel kann die Zellinformation wiederholt während des Betriebs des Batteriesystems erfasst werden, um eine Überwachung des Batteriesystems zu gewährleisten. Es kann sich dabei um eine sicherheitsrelevante Überwachung handeln, sodass die Übertragung der Zellinformation zum Beispiel über das Kommunikationssystem einem Sicherheitsstandard genügen muss. Entsprechend sollte auch die Umwandlung der über das Übertragungssystem übertragenen Zellinformation in die Ausgabebotschaft für das Kommunikationssystem einem Sicherheitsstandard genügen. Ein solcher Sicherheitsstandard kann beispielsweise ein ASIL-Standard sein, sodass bei der beschriebenen Anpassung der Zellinformation eine ASIL-C- oder ASIL-D-konforme Mikrocontrollertopologie verwendet werden kann. Um dem Sicherheitsstandard zu genügen, ist es beispielsweise bekannt, relativ komplexe und/oder kostenaufwendige Dual-Core- oder Multi-Core- oder Lockstep-Mikrocontroller zu verwenden. Erfindungsgemäß kann es dabei gegebenenfalls vorgesehen sein, dass stattdessen zwei Single-Core-Mikrocontroller als das erste und zweite Verarbeitungselement verwendet werden. Hierdurch lässt sich der Kostenaufwand reduzieren.

Es kann daher möglich sein, dass das erste und/oder zweite Verarbeitungselement jeweils als Mikrocontroller, vorzugsweise als Single-Core-, bevorzugt Einzelkern-Mikrocontroller ausgeführt ist.

Ferner kann im Rahmen der Erfindung vorgesehen sein, dass das erste Verarbeitungselement dazu ausgeführt ist, die Prüfinformation als einen Prüfwert für die Nachricht anhand der Nachricht (und/oder anhand der ersten Daten) gemäß der ersten Verarbeitung zu generieren, sodass der Prüfwert zur Überprüfung auch der Nachricht gemäß der zweiten Verarbeitung (beziehungsweise der zweiten Daten) ausgeführt ist. Somit ist insbesondere eine gegenseitige Überwachung durch die Verarbeitungselemente dadurch möglich, dass beide durch die Verarbeitungselemente generierten Nachrichten identisch sind, damit anhand der Prüfinformation der Ausgabebotschaft der weitere Teil der Ausgabebotschaft (also die Nachricht gemäß der zweiten Verarbeitung) als fehlerfrei erkannt wird. Insbesondere kann es möglich sein, dass zur Kontrolle der Fehlerfreiheit der Prüfwert mit weiteren Daten der Ausgabebotschaft, insbesondere der Nachricht gemäß der zweiten Verarbeitung, verglichen wird. Wenn dieser Vergleich das gleiche Vergleichsergebnis hervorbringt, wie ein Vergleich des Prüfwertes mit der Nachricht gemäß der ersten Verarbeitung, so kann die Ausgabebotschaft als fehlerfrei erkannt werden. Andernfalls kann es vorgesehen sein, dass die Ausgabebotschaft verworfen wird.

Optional kann vorgesehen sein, dass die Ausgabebotschaft und/oder die Nachricht an eine Übertragung mit dem Kommunikationssystem dadurch angepasst ist, dass die Ausgabebotschaft ein vollständiges oder teilweises Datenpaket, vorzugsweise Telegramm, für das Kommunikationssystem ausbildet, wobei ggf. das Datenpaket auch die Prüfinformation aufweist, um durch das Kommunikationssystem und/oder durch wenigstens einen Kommunikationsteilnehmer (wie ein Steuergerät oder BMC des Fahrzeuges) die Korrektheit der Nachricht gemäß der zweiten Verarbeitung und/oder des Datenpakets zu überprüfen. Bei dem Datenpaket kann es sich zum Beispiel um ein CAN-Bus-Telegramm handeln. CAN steht hierbei für Controller Area Network, wobei im vorliegenden Fall, darunter auch ein Battery-CAN oder ein spezialisiertes CAN oder dergleichen verstanden werden kann. Damit ist eine zuverlässige Übertragung, zum Beispiel an Steuergeräte des Fahrzeuges, möglich.

Bevorzugt kann im Rahmen der Erfindung vorgesehen sein, dass die Kommunikationssystemschnittstelle als Schnittstelle für ein CAN-Bussystem als das Kommunikationssystem ausgebildet ist, wobei das Datenpaket als Telegramm des CAN-Busses ausgeführt ist. Die Kommunikationssystemschnittstelle (oder kurz Kommunikationsschnittstelle) kann beispielsweise auch als ein CAN-Transceiver oder dergleichen ausgeführt sein, um eine Kommunikation über das Kommunikationssystem zu ermöglichen.

Ferner ist bei einer Schaltungsanordnung optional vorgesehen, dass das erste und zweite Verarbeitungselement als baulich und/oder funktionell gleiche oder gleichartige integrierte Schaltkreise, vorzugsweise Mikrocontroller, ausgebildet sind, sodass die Nachricht gemäß der ersten und zweiten Verarbeitung redundant generiert wird. Beispielsweise können sowohl das erste Verarbeitungselement als auch das zweite Verarbeitungselement die Zellinformationen (zum Beispiel als TPL-Signal) empfangen und jeweils decodieren, sodass durch diese decodierte Information eine Ausgabebotschaft, wie eine CAN-Botschaft, generiert werden kann. Hierdurch ist eine gegenseitige Überwachung der Verarbeitungselemente möglich.

Ferner kann es bei der erfindungsgemäßen Schaltungsanordnung möglich sein, dass eines der Verarbeitungselemente die Kommunikationssystemschnittstelle aufweist, und/oder dass eine zu den Verarbeitungselementen baulich separate Kommunikationssystemschnittstelle vorgesehen ist, welche mit wenigstens einer der Verarbeitungselemente zur Übertragung der Ausgabebotschaft verschaltet ist. Beispielsweise kann nur das zweite Verarbeitungselement eine höhere Komplexität aufweisen als das erste Verarbeitungselement, sodass hier gegebenenfalls eine weitere Kostenersparnis möglich ist.

Des Weiteren ist es im Rahmen der Erfindung optional möglich, dass das erste Verarbeitungselement mit dem zweiten Verarbeitungselement verschaltet ist, um dem zweiten Verarbeitungselement die Prüfinformation zu übergeben, um diese in die Ausgabebotschaft zu integrieren. Beispielsweise ist das erste Verarbeitungselement direkt elektrisch mit dem zweiten Verarbeitungselement verbunden, um eine zuverlässige Übertragung der Prüfinformation zu ermöglichen. Dabei ist es gegebenenfalls nicht mehr notwendig, dass auch das zweite Verarbeitungselement die Prüfinformation generieren muss. In anderen Worten kann gegebenenfalls direkt die durch die erste Verarbeitung generierte Prüfinformation ohne weitere Veränderung in die Ausgabebotschaft integriert werden. Damit ist gewährleistet, dass die erste Verarbeitung die zweite Verarbeitung überprüfen kann.

Darüber hinaus ist optional vorgesehen, dass das zweite Verarbeitungselement oder die Kommunikationssystemschnittstelle dazu ausgeführt ist, anhand der Prüfinformation gemäß der ersten Verarbeitung und der Nachricht gemäß der zweiten Verarbeitung die Ausgabebotschaft zu generieren. Beispielsweise können die Kommunikationssystemschnittstelle und/oder das zweite Verarbeitungselement derart programmiert sein, dass es aus der Nachricht und der Prüfinformation eine CAN-Botschaft generieren kann. Dies ermöglicht eine zulässige Kommunikation zum Beispiel zu einem Steuergerät des Fahrzeuges.

Weiter ist es im Rahmen der Erfindung möglich, dass sowohl das erste Verarbeitungselement als auch das zweite Verarbeitungselement jeweils mit einem Übertragungsmittel verbunden sind, um ein Signal mit der Zellinformation zu erhalten, insbesondere zur Generierung der Nachricht anhand der Zellinformation durch die Verarbeitungselemente unabhängig voneinander. Es kann zum Beispiel notwendig sein, dass zur Generierung der Prüfinformation (durch die erste Verarbeitung) auch eine Generierung der Nachricht notwendig ist, da die Prüfinformation gegebenenfalls von der generierten Nachricht abhängig ist. Somit wird eine höhere Sicherheit gewährleistet.

Außerdem ist es von Vorteil, wenn bei einer Schaltungsanordnung ein Sicherheitsmechanismus vorgesehen ist, um die Ausgabebotschaft zu verwerfen, falls eine Prüfung der Nachricht anhand der Prüfinformation jeweils als Teile der Ausgabebotschaft einen Fehler wenigstens einer dieser Teile detektiert. In anderen Worten sind die Nachricht (gemäß der zweiten Verarbeitung) und die Prüfinformation (gemäß der ersten Verarbeitung) jeweils Teile der Ausgabebotschaft, wobei insbesondere die Nachricht gemäß der ersten Verarbeitung nicht verwendet und/oder verworfen wird. Somit kann eine gegenseitige Kontrolle durch die Verarbeitungselemente bereitgestellt werden. Das Verwerfen und/oder die Prüfung der Ausgabebotschaft kann beispielsweise durch eines der Verarbeitungselemente und/oder durch die Kommunikationssystemschnittstelle und/oder durch einen weiteren Kommunikationsteilnehmer des Kommunikationssystems, wie ein Steuergerät des Fahrzeuges, erfolgen.

Ebenfalls Gegenstand der Erfindung ist ein Verfahren zur Anpassung wenigstens einer Zellinformation über wenigstens eine Batteriezelle an ein Kommunikationssystem eines Fahrzeuges.

Hierbei ist vorgesehen, dass die nachfolgenden Schritte durchgeführt werden, vorzugsweise nacheinander oder in beliebiger Reihenfolge:
a) Generieren einer Nachricht sowie einer Prüfinformation gemäß einer ersten Verarbeitung durch ein erstes Verarbeitungselement, wobei die Nachricht für die Zellinformation spezifisch ist, vorzugsweise abhängig ist von der Zellinformation,
b) Generieren der gleichen Nachricht gemäß wenigstens einer zweiten Verarbeitung durch wenigstens ein zweites Verarbeitungselement,
c) Ausgabe einer Ausgabebotschaft an das Kommunikationssystem durch eine Kommunikationssystemschnittstelle, wobei die Ausgabebotschaft sich zumindest teilweise aus der Nachricht gemäß der zweiten Verarbeitung sowie der Prüfinformation (generiert durch das erste Verarbeitungselement) zusammensetzt, sodass die Ausgabebotschaft für die erste und zweite Verarbeitung spezifisch ist.

Damit bringt das erfindungsgemäße Verfahren die gleichen Vorteile mit sich, wie sie ausführlich mit Bezug auf eine erfindungsgemäße Schaltungsanordnung beschrieben worden sind. Zudem kann das Verfahren geeignet sein, eine erfindungsgemäße Schaltungsanordnung zu betreiben.

In einer weiteren Möglichkeit kann vorgesehen sein, dass die erste Verarbeitung eine Erzeugung der Prüfinformation als CRC-Prüfwert gemäß einer zyklischen Redundanzprüfung (kurz: CRC) umfasst. Hierdurch kann eine besonders hohe Zuverlässigkeit bei der Fehlerkontrolle bereitgestellt werden.

Des Weiteren kann vorgesehen sein, dass das erste und/oder zweite Verarbeitungselement und/oder die Kommunikationssystemschnittstelle gemäß einer erfindungsgemäßen Schaltungsanordnung ausgebildet sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine schematische Darstellung einer erfindungsgemäßen Schaltungsanordnung,
- Figur 2: eine schematische Darstellung zur Visualisierung eines erfindungsgemäßen Verfahrens,
- Figur 3: eine schematische Darstellung eines Systems mit der erfindungsgemäßen Schaltungsanordnung.

In den nachfolgenden Figuren werden für die gleichen technischen Merkmale auch von unterschiedlichen Ausführungsbeispielen die identischen Bezugszeichen verwendet.

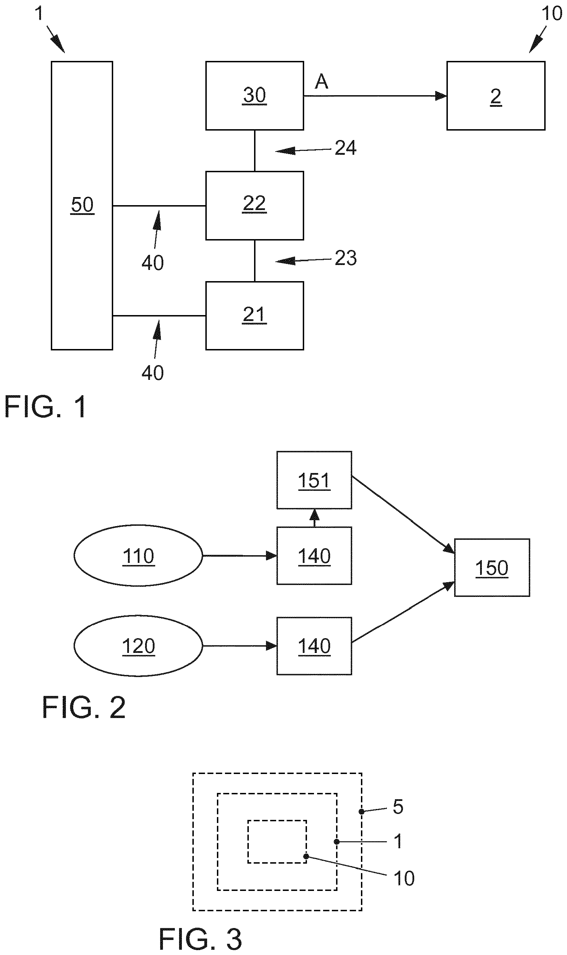

In Figur 1 gezeigt ist eine erfindungsgemäße Schaltungsanordnung 10 für ein Batteriemanagementsystem 1, zur Anpassung wenigstens einer Zellinformation über wenigstens eine Batteriezelle an ein Kommunikationssystem 2 eines Fahrzeuges 5.

Es kann dabei ein erstes Verarbeitungselement 21 zur Generierung einer Nachricht 140 sowie einer Prüfinformation 151 gemäß einer ersten Verarbeitung 110 vorgesehen sein, wobei die Nachricht 140 für die Zellinformation spezifisch ist, insbesondere einen Messwert erfasst. Insbesondere kann die Prüfinformation 151 in Abhängigkeit von der Nachricht 140 generiert werden, z. B. anhand eines (Daten- und/oder weiteren) Inhalts der Nachricht 140 berechnet werden (in anderen Worten: die Prüfinformation 151 wird aus der Nachricht 140 gebildet). Hierzu wird z. B. zunächst ein Signal mit der Zellinformation von einem Übertragungssystem 50 erhalten, anschließend dekodiert und daraus die Nachricht 140 erzeugt. Die Nachricht 140 bildet dabei z. B. eine CAN-Botschaft aus Adressinformation und Dateninhalt. Der Inhalt der Nachricht 140 kann z. B. mittels CRC genutzt werden, um die Prüfinformation 151 zu berechnen.

Ferner kann wenigstens ein zweites Verarbeitungselement 22 zur Generierung der gleichen Nachricht 140 gemäß wenigstens einer zweiten Verarbeitung 120 vorgesehen sein.

Das erste und zweite Verarbeitungselement 21, 22 können als baulich und/oder funktionell gleiche oder gleichartige integrierte Schaltkreise ausgebildet sein, vorzugsweise als Mikrocontroller. Damit kann die Nachricht 140 gemäß der ersten und zweiten Verarbeitung 110, 120 redundant generiert werden.

Es ist erkennbar, dass das erste Verarbeitungselement 21 mit dem zweiten Verarbeitungselement 22 verschaltet ist, um dem zweiten Verarbeitungselement 22 die Prüfinformation 151 zu übergeben, um diese in die Ausgabebotschaft 150 zu integrieren. Beispielsweise ist das erste Verarbeitungselement 21 direkt mit dem zweiten Verarbeitungselement 22 über ein erstes Verbindungsmittel 23, wie einer seriellen Schnittstelle und/oder einer UART-Schnittstelle, verbunden. UART steht hierbei für Universal Asynchronous Receiver Transmitter.

Sowohl das erste Verarbeitungselement 21 als auch das zweite Verarbeitungselement 22 können jeweils mit einem Übertragungsmittel 40 verbunden sein, um ein Signal mit der Zellinformation von einem Übertragungssystem 50 zu erhalten, und um jeweils eine Generierung der Nachricht 140 anhand der Zellinformation unabhängig voneinander durchzuführen. Das Übertragungssystem 50 umfasst z B. ein TPL-Protokoll und/oder eine SPI-Schnittstelle (SPI steht hierbei für Serial Peripheral Interface), und ist zum Beispiel mit wenigstens einem Überwachungsmittel einer jeweiligen Zelle verbunden.

Darüber hinaus ist eine von den Verarbeitungselementen 21, 22 separate oder in eines der Verarbeitungselemente 21, 22 integrierte Kommunikationssystemschnittstelle 30 zur Ausgabe A einer Ausgabebotschaft 150 an das Kommunikationssystem 2 vorgesehen. Die Kommunikationssystemschnittstelle 30 ist zum Beispiel direkt mit dem zweiten Verarbeitungselement 22 über ein zweites Verbindungsmittel 24, wie einem Bus-System und/oder einer SPI-Schnittstelle und/oder über ein Battery-CAN-Bussystem verbunden.

Die Kommunikationssystemschnittstelle 30 kann zum Beispiel als Schnittstelle für ein CAN-Bussystem als das Kommunikationssystem 2 ausgebildet sein, wobei das Datenpaket 150 als Telegramm 150 des CAN-Busses ausgeführt ist.

Wie in Figur 2 näher dargestellt ist, wird zur Durchführung der Ausgabe die Ausgabebotschaft 150 zumindest teilweise aus der Nachricht 140 gemäß der zweiten Verarbeitung 120 sowie der Prüfinformation 151 zusammengesetzt, sodass die Ausgabebotschaft 150 für die erste und zweite Verarbeitung 120 spezifisch ist. Damit ist eine gegenseitige Überwachung der fehlerfreien Verarbeitung durch die Verarbeitungselemente 21, 22 möglich.

Das erste Verarbeitungselement 21 kann ferner dazu ausgeführt sein, die Prüfinformation 151 als einen Prüfwert für die Nachricht 140 anhand der Nachricht 140 gemäß der ersten Verarbeitung 110 zu generieren, sodass der Prüfwert zur Überprüfung auch der Nachricht 140 gemäß der zweiten Verarbeitung 120 ausgeführt ist.

Darüber hinaus kann die Ausgabebotschaft 150 und/oder die Nachricht 140 an eine Übertragung mit dem Kommunikationssystem 2 dadurch angepasst sein, dass die Ausgabebotschaft 150 ein vollständiges oder teilweises Datenpaket 150 für das Kommunikationssystem 2 ausbildet. Hierbei kann das Datenpaket 150 auch die Prüfinformation 151 aufweisen, um durch das Kommunikationssystem 2 und/oder durch wenigstens einen Kommunikationsteilnehmer die Korrektheit der Nachricht 140 gemäß der zweiten Verarbeitung 120 und/oder des Datenpakets 150 zu überprüfen.

Vorteilhaft ist es, wenn ein Sicherheitsmechanismus vorgesehen ist, um die Ausgabebotschaft 150 zu verwerfen, falls eine Prüfung der Nachricht 140 anhand der Prüfinformation 151 jeweils als Teile der Ausgabebotschaft 150 einen Fehler wenigstens einer dieser Teile detektiert.

Durch Figur 2 ist außerdem ein erfindungsgemäßes Verfahren visualisiert, wobei zunächst eine Generierung einer Nachricht 140 sowie einer Prüfinformation 151 gemäß einer ersten Verarbeitung 110 erfolgt, dann eine Generierung der gleichen Nachricht 140 gemäß wenigstens einer zweiten Verarbeitung 120 erfolgt, und anschließend eine Ausgabe einer Ausgabebotschaft 150 an das Kommunikationssystem 2 durchgeführt wird. Hierbei kann die Ausgabebotschaft 150 sich zumindest teilweise aus der Nachricht 140 gemäß der zweiten Verarbeitung 120 sowie der Prüfinformation 151 zusammensetzen, sodass die Ausgabebotschaft 150 für die erste und zweite Verarbeitung 120 spezifisch ist.

In Figur 3 ist schematisch dargestellt, dass die erfindungsgemäße Schaltungsanordnung 10 Teil eines Batteriemanagementsystems 1 eines Fahrzeuges 5 sein kann.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: System, Batteriemanagementsystem
- 2: Kommunikationssystem
- 5: Fahrzeug

- 10: Schaltungsanordnung

- 21: erstes Verarbeitungselement
- 22: zweites Verarbeitungselement
- 23: erstes Verbindungsmittel
- 24: zweites Verbindungsmittel

- 30: Kommunikationssystemschnittstelle

- 40: Übertragungsmittel

- 50: Übertragungssystem

- 110: erste Verarbeitung

- 120: zweite Verarbeitung

- 140: Nachricht
- 150: Ausgabebotschaft, Datenpaket, Telegramm
- 151: Prüfinformation

- A: Ausgang

## Patentansprüche

1. Schaltungsanordnung (10) für ein Batteriemanagementsystem (1) eines Fahrzeuges (5), zur Anpassung wenigstens einer Zellinformation über wenigstens eine Batteriezelle an ein Kommunikationssystem (2) des Fahrzeuges (5), aufweisend:
- ein erstes Verarbeitungselement (21) zur Generierung einer Nachricht (140) sowie einer Prüfinformation (151) gemäß einer ersten Verarbeitung (110), wobei die Nachricht (140) für die Zellinformation spezifisch ist,
- wenigstens ein zweites Verarbeitungselement (22) zur Generierung der gleichen Nachricht (140) gemäß wenigstens einer zweiten Verarbeitung (120),
- eine Kommunikationssystemschnittstelle (30) zur Ausgabe einer Ausgabebotschaft (150) an das Kommunikationssystem (2), wobei die Ausgabebotschaft (150) sich zumindest teilweise aus der Nachricht (140) gemäß der zweiten Verarbeitung (120) sowie der Prüfinformation (151) zusammensetzt, sodass die Ausgabebotschaft (150) für die erste und zweite Verarbeitung (120) spezifisch ist.

2. Schaltungsanordnung (10) nach Anspruch 1,
**dadurch gekennzeichnet,**
**dass** das erste Verarbeitungselement (21) dazu ausgeführt ist, die Prüfinformation (151) als einen Prüfwert für die Nachricht (140) anhand der Nachricht (140) gemäß der ersten Verarbeitung (110) zu generieren, sodass der Prüfwert zur Überprüfung auch der Nachricht (140) gemäß der zweiten Verarbeitung (120) ausgeführt ist.

3. Schaltungsanordnung (10) nach Anspruch 1 oder 2,
**dadurch gekennzeichnet,**
**dass** die Ausgabebotschaft (150) und/oder die Nachricht (140) an eine Übertragung mit dem Kommunikationssystem (2) dadurch angepasst ist, dass die Ausgabebotschaft (150) ein vollständiges oder teilweises Datenpaket (150) für das Kommunikationssystem (2) ausbildet, wobei das Datenpaket (150) auch die Prüfinformation (151) aufweist, um durch das Kommunikationssystem (2) und/oder durch wenigstens einen Kommunikationsteilnehmer die Korrektheit der Nachricht (140) gemäß der zweiten Verarbeitung (120) und/oder des Datenpakets (150) zu überprüfen.

4. Schaltungsanordnung (10) nach einem der vorhergehenden Ansprüche,
**dadurch gekennzeichnet,**
**dass** die Kommunikationssystemschnittstelle (30) als Schnittstelle für ein CAN-Bussystem als das Kommunikationssystem (2) ausgebildet ist, wobei das Datenpaket (150) als Telegramm (150) des CAN-Busses ausgeführt ist.

5. Schaltungsanordnung (10) nach einem der vorhergehenden Ansprüche,
**dadurch gekennzeichnet,**
**dass** das erste und zweite Verarbeitungselement (21, 22) als baulich und/oder funktionell gleiche oder gleichartige integrierte Schaltkreise, vorzugsweise Mikrocontroller, ausgebildet sind, sodass die Nachricht (140) gemäß der ersten und zweiten Verarbeitung (110, 120) redundant generiert wird.

6. Schaltungsanordnung (10) nach einem der vorhergehenden Ansprüche,
**dadurch gekennzeichnet,**
**dass** das erste Verarbeitungselement (21) mit dem zweiten Verarbeitungselement (22) verschaltet ist, um dem zweiten Verarbeitungselement (22) die Prüfinformation (151) zu übergeben, um diese in die Ausgabebotschaft (150) zu integrieren.

7. Schaltungsanordnung (10) nach einem der vorhergehenden Ansprüche,
**dadurch gekennzeichnet,**
**dass** sowohl das erste Verarbeitungselement (21) als auch das zweite Verarbeitungselement (22) jeweils mit einem Übertragungsmittel (40) verbunden sind, um ein Signal mit der Zellinformation zu erhalten, zur Generierung der Nachricht (140) anhand der Zellinformation durch die Verarbeitungselemente (21, 22) unabhängig voneinander.

8. Schaltungsanordnung (10) nach einem der vorhergehenden Ansprüche,
**dadurch gekennzeichnet,**
**dass** ein Sicherheitsmechanismus vorgesehen ist, um die Ausgabebotschaft (150) zu verwerfen, falls eine Prüfung der Nachricht (140) anhand der Prüfinformation (151) jeweils als Teile der Ausgabebotschaft (150) einen Fehler wenigstens einer dieser Teile detektiert.

9. Verfahren zur Anpassung wenigstens einer Zellinformation über wenigstens eine Batteriezelle an ein Kommunikationssystem (2) eines Fahrzeuges (5), wobei die nachfolgenden Schritte durchgeführt werden:
a) Generierung einer Nachricht (140) sowie einer Prüfinformation (151) gemäß einer ersten Verarbeitung (110) durch ein erstes Verarbeitungselement (21), wobei die Nachricht (140) für die Zellinformation spezifisch ist,
b) Generierung der gleichen Nachricht (140) gemäß wenigstens einer zweiten Verarbeitung (120) durch wenigstens ein zweites Verarbeitungselement (22),
c) Ausgabe einer Ausgabebotschaft (150) an das Kommunikationssystem (2) durch eine Kommunikationssystemschnittstelle (30), wobei die Ausgabebotschaft (150) sich zumindest teilweise aus der Nachricht (140) gemäß der zweiten Verarbeitung (120) sowie der Prüfinformation (151) zusammensetzt, sodass die Ausgabebotschaft (150) für die erste und zweite Verarbeitung (120) spezifisch ist.

10. Verfahren nach Anspruch 9,
**dadurch gekennzeichnet,**
**dass** die erste Verarbeitung (110) eine Erzeugung der Prüfinformation als CRC-Prüfwert gemäß einer zyklischen Redundanzprüfung umfasst.

11. Verfahren nach Anspruch 9 oder 10,
**dadurch gekennzeichnet,**
**dass** das erste und/oder zweite Verarbeitungselement (21, 22) und/oder die Kommunikationssystemschnittstelle (30) gemäß einer Schaltungsanordnung (10) nach einem der Ansprüche 1 bis 8 ausgebildet ist.

## Claims

1. Circuit arrangement (10) for a battery management system (1) of a vehicle (5), for adapting at least one item of cell information about at least one battery cell to a communication system (2) of the vehicle (5), having:
- a first processing element (21) for generating a message (140) and check information (151) in accordance with a first processing operation (110), wherein the message (140) is specific to the cell information,
- at least one second processing element (22) for generating the same message (140) in accordance with at least one second processing operation (120),
- a communication system interface (30) for outputting an output notification (150) to the communication system (2), wherein the output notification (150) is at least partially made up of the message (140) in accordance with the second processing operation (120) and the check information (151) such that the output notification (150) is specific to the first and second processing operation (120) .

2. Circuit arrangement (10) according to Claim 1,
**characterized**
**in that** the first processing element (21) is configured to generate the check information (151) as a check value for the message (140) on the basis of the message (140) in accordance with the first processing operation (110) such that the check value is also configured to examine the message (140) in accordance with the second processing operation (120).

3. Circuit arrangement (10) according to Claim 1 or 2,
**characterized**
**in that** the output notification (150) and/or the message (140) are/is adapted to a transmission using the communication system (2) in such a way that the output notification (150) forms a complete or partial data packet (150) for the communication system (2), wherein the data packet (150) also contains the check information (151) in order to examine the correctness of the message (140) in accordance with the second processing operation (120) and/or the data packet (150) by way of the communication system (2) and/or by way of at least one communication subscriber.

4. Circuit arrangement (10) according to one of the preceding claims,
**characterized**
**in that** the communication system interface (30) is in the form of an interface for a CAN bus system as the communication system (2), wherein the data packet (150) is configured as a telegram (150) of the CAN bus.

5. Circuit arrangement (10) according to one of the preceding claims,
**characterized**
**in that** the first and second processing element (21, 22) are in the form of structurally and/or functionally identical or similar integrated circuits, preferably microcontrollers, such that the message (140) is generated in a redundant manner in accordance with the first and second processing operation (110, 120).

6. Circuit arrangement (10) according to one of the preceding claims,
**characterized**
**in that** the first processing element (21) is connected to the second processing element (22) in order to transfer the check information (151) to the second processing element (22) in order to integrate said information into the output notification (150).

7. Circuit arrangement (10) according to one of the preceding claims,
**characterized**
**in that** both the first processing element (21) and the second processing element (22) are each connected to a transmission means (40) in order to obtain a signal containing the cell information to generate the message (140) by way of the processing elements (21, 22) independently of one another on the basis of the cell information.

8. Circuit arrangement (10) according to one of the preceding claims,
**characterized**
**in that** a security mechanism is provided in order to discard the output notification (150) if a check of the message (140), on the basis of the check information (151) in each case as parts of the output notification (150), detects an error in at least one of said parts.

9. Method for adapting at least one item of cell information about at least one battery cell to a communication system (2) of a vehicle (5), wherein the following steps are carried out:
a) generating a message (140) and check information (151) by way of a first processing element (21) in accordance with a first processing operation (110), wherein the message (140) is specific to the cell information,
b) generating the same message (140) by way of at least one second processing element (22) in accordance with at least one second processing operation (120),
c) outputting an output notification (150) to the communication system (2) by way of a communication system interface (30), wherein the output notification (150) is at least partially made up of the message (140) in accordance with the second processing operation (120) and the check information (151) such that the output notification (150) is specific to the first and second processing operation (120).

10. Method according to Claim 9,
**characterized**
**in that** the first processing operation (110) comprises producing the check information as CRC check value in accordance with a cyclic redundancy check.

11. Method according to Claim 9 or 10,
**characterized**
**in that** the first and/or second processing element (21, 22) and/or the communication system interface (30) are/is designed in accordance with a circuit arrangement (10) according to one of Claims 1 to 8.

## Revendications

1. Arrangement de circuit (10) pour un système de gestion de batterie (1) d'un véhicule (5), destiné à adapter au moins une information de cellule à propos d'au moins une cellule de batterie à un système de communication (2) du véhicule (5), comprenant :
- un premier élément de traitement (21) destiné à générer une notification (140) ainsi qu'une information de contrôle (151) conformément à un premier traitement (110), la notification (140) étant spécifique à l'information de cellule,
- au moins un deuxième élément de traitement (22) destiné à générer la même notification (140) conformément à au moins un deuxième traitement (120),
- une interface de système de communication (30) destinée à délivrer un message de délivrance (150) au système de communication (2), le message de délivrance (150) se composant au moins partiellement de la notification (140) conformément au deuxième traitement (120) ainsi que de l'information de contrôle (151), de sorte que le message de délivrance (150) est spécifique pour le premier et le deuxième traitement (120).

2. Arrangement de circuit (10) selon la revendication 1, **caractérisé en ce que** le premier élément de traitement (21) est conçu pour générer l'information de contrôle (151) sous la forme d'une valeur de contrôle pour la notification (140) à l'aide de la notification (140) conformément au premier traitement (110), de sorte que la valeur de contrôle est également conçue pour contrôler la notification (140) conformément au deuxième traitement (120).

3. Arrangement de circuit (10) selon la revendication 1 ou 2, **caractérisé en ce que** le message de délivrance (150) et/ou la notification (140) sont adaptés à une transmission avec le système de communication (2) **en ce que** le message de délivrance (150) forme un paquet de données (150) complet ou partiel pour le système de communication (2), le paquet de données (150) comprenant également l'information de contrôle (151) afin de contrôler, par le système de communication (2) et/ou par au moins un participant de communication, le caractère correct de la notification (140) conformément au deuxième traitement (120) et/ou du paquet de données (150).

4. Arrangement de circuit (10) selon l'une des revendications précédentes, **caractérisé en ce que** l'interface de système de communication (30) est réalisée sous la forme d'une interface pour un système de bus CAN en tant que système de communication (2), le paquet de données (150) étant conçu en tant que télégramme (150) du bus CAN.

5. Arrangement de circuit (10) selon l'une des revendications précédentes, **caractérisé en ce que** le premier et le deuxième élément de traitement (21, 22) sont réalisés sous la forme de circuits intégrés, de préférence de microcontrôleurs, constructivement et/ou fonctionnellement identiques ou du même type, de sorte que la notification (140) conformément au premier et au deuxième traitement (110, 120) est générée de manière redondante.

6. Arrangement de circuit (10) selon l'une des revendications précédentes, **caractérisé en ce que** le premier élément de traitement (21) est connecté au deuxième élément de traitement (22) afin de transmettre l'information de contrôle (151) au deuxième élément de traitement (22) afin d'intégrer celle-ci dans le message de délivrance (150).

7. Arrangement de circuit (10) selon l'une des revendications précédentes, **caractérisé en ce que** le premier élément de traitement (21) ainsi que le deuxième élément de traitement (22) sont respectivement reliés à un moyen de transmission (40) afin d'obtenir un signal comportant l'information de cellule, en vue de générer la notification (140) à l'aide de l'information de cellule par les éléments de traitement (21, 22) indépendamment l'un de l'autre.

8. Arrangement de circuit (10) selon l'une des revendications précédentes, **caractérisé en ce qu'**un mécanisme de sécurité est présent afin de rejeter le message de délivrance (150) dans le cas où un contrôle de la notification (140) à l'aide de l'information de contrôle (151) respectivement en tant que parties du message de délivrance (150) détecte une erreur d'au moins l'une de ces parties.

9. Procédé d'adaptation d'au moins une information de cellule à propos d'au moins une cellule de batterie à un système de communication (2) d'un véhicule (5), les étapes suivantes étant exécutées :
a) génération d'une notification (140) ainsi qu'une information de contrôle (151) conformément à un premier traitement (110) par un premier élément de traitement (21), la notification (140) étant spécifique à l'information de cellule,
b) génération de la même notification (140) conformément à au moins un deuxième traitement (120) par au moins un deuxième élément de traitement (22),
c) délivrance d'un message de délivrance (150) au système de communication (2) à travers une interface de système de communication (30), le message de délivrance (150) se composant au moins partiellement de la notification (140) conformément au deuxième traitement (120) ainsi que de l'information de contrôle (151), de sorte que le message de délivrance (150) est spécifique pour le premier et le deuxième traitement (120).

10. Procédé selon la revendication 9, **caractérisé en ce que** le premier traitement (110) comprend une génération de l'information de contrôle sous la forme d'une valeur de contrôle de CRC conformément à un contrôle de redondance cyclique.

11. Procédé selon la revendication 9 ou 10, **caractérisé en ce que** le premier et/ou le deuxième élément de traitement (21, 22) et/ou l'interface de système de communication (30) sont réalisés selon l'une des revendications 1 à 8.
